# EUROPEAN PATENT APPLICATION

(11) **EP 2 426 787 A1**
(43) Date of publication of application: **07.03.2012**
(21) Application number: 10769664.3
(22) Date of filing: 22.04.2010
(51) Int. Cl.: H01R 11/01, C09D 5/25, C09D 133/00, C09D 179/08, C09D 183/04, C09J 9/02, C09J 11/04, C09J 11/06, C09J 163/00, H01B 1/00, H01B 1/22, H01B 1/24, H05K 1/14, H05K 3/32, H05K 3/36

(54) **CIRCUIT CONNECTING MATERIAL, FILM-LIKE CIRCUIT CONNECTING MATERIAL USING THE CIRCUIT CONNECTING MATERIAL, STRUCTURE FOR CONNECTING CIRCUIT MEMBER, AND METHOD FOR CONNECTING CIRCUIT MEMBER**

(30) Priority: 28.04.2009 JP 2009109102
(71) Applicant: Hitachi Chemical Company, Ltd., Tokyo 163-0449 (JP)
(72) Inventor: ARIFUKU Motohiro, Chikusei-shi Ibaraki 308-8524 (JP); KOBAYASHI Kouji, Chikusei-shi Ibaraki 308-8524 (JP); FUJINAWA Tohru, Chikusei-shi Ibaraki 308-8524 (JP)
(74) Representative: Siegert, Georg
(86) International application number: PCT/JP2010/057165
(87) International publication number: WO 2010/125965

(57) **Abstract**

The circuit connecting material of the invention is situated between mutually opposing circuit electrodes, and provides electrical connection between the electrodes in the pressing direction when the mutually opposing circuit electrodes are pressed, the circuit connecting material comprising anisotropic conductive particles wherein conductive fine particles are dispersed in an organic insulating material.

## Description

### Technical Field

The present invention relates to a circuit connecting material, a film-like circuit connecting material using it, a structure for connecting a circuit member and a method for connecting a circuit member.

### Background Art

Circuit connecting materials comprising anisotropic conductive adhesives, in which conductive particles are dispersed in an adhesive, have conventionally been used for connection between liquid crystal displays and TCPs (Tape Carrier Packages), connection between FPCs (Flexible Printed Circuits) and TCPs, and connection between FPCs and printed circuit boards. Recently, flip-chip mounting, for direct mounting of semiconductor silicon chips on boards in a face-down manner, is being used even for mounting of semiconductor silicon chips on boards instead of conventional wire bonding, and anisotropic conductive adhesives have begun to be applied here as well (see Patent documents 1-4).

Incidentally, as densification of circuit electrodes continues to advance with downsizing and reduced thicknesses of electronic products in recent years, circuit spacings and circuit widths have become extremely small.

The circuit connecting materials there have conventionally been used include anisotropic conductive adhesives dispersing, as conductive particles, nickel particles in an organic insulating adhesive or metal-plated resin particles having nickel or gold plated on plastic particle surfaces. However, when such circuit connecting materials are used for connection in high-density circuits, the conductive particles often form links between adjacent circuits, causing shorting.

Measures proposed as solutions to this problem include coating an insulating resin on the conductive particle surfaces (see Patent document 5), and immobilizing insulating fine particles on the conductive particle surfaces (see Patent document 6).

### [Citation List]

### [Patent literature]

[Patent document 1] Japanese Unexamined Patent Application Publication SHO No. 59-120436
[Patent document 2] Japanese Unexamined Patent Application Publication SHO No. 60-191228
[Patent document 3] Japanese Unexamined Patent Application Publication HEI No. 1-251787
[Patent document 4] Japanese Unexamined Patent Application Publication HEI No. 7-90237
[Patent document 5] Japanese Patent Publication No. 2546262
[Patent document 6] Japanese Unexamined Patent Application Publication No. 2007-258141

### Summary of Invention

### Technical Problem

Even with the conductive particles described in Patent documents 5 and 6, however, friction between adjacent conductive particles during circuit connection can result in flaking off of the insulating resin coating on the conductive particle surfaces or the insulating fine particles immobilized on the conductive particles, thus exposing the metal on the particle surfaces and creating shorts.

It is an object of the present invention, which has been accomplished in light of the aforementioned problems of the prior art, to provide a circuit connecting material which can both ensure insulation between adjacent circuits in a high-definition circuit and ensure conductivity between opposing circuits, as well as a film-like circuit connecting material using it, a structure for connecting a circuit member, and a method for connecting a circuit member.

### Solution to Problem

As a result of much diligent research directed toward solving the problems mentioned above, the present inventors focused on the fact that the conduction between circuit electrodes of circuit connecting materials containing conductive particles is supported by the plurality of conductive particles present between mutually opposing circuits, but that in terms of the individual conductive particles, whereas one conductive particle is flat and reaches to contact with both mutually opposing electrodes, two or more conductive particles between adjacent circuits that require electrical insulation become connected with almost no flattening, thus creating shorts, and have found that this problem can be overcome by changing the resistance value before and after flattening of the conductive particles.

In other words, the present invention provides a circuit connecting material situated between mutually opposing circuit electrodes, which provides electrical connection between the electrodes in the pressing direction when the mutually opposing circuit electrodes are pressed, the circuit connecting material comprising anisotropic conductive particles wherein conductive fine particles are dispersed in an organic insulating material. Since the anisotropic conductive particles in the circuit connecting material have conductive fine particles dispersed in an organic insulating material, the insulating property is maintained before deformation to a flat state by pressing during circuit connection, while conductivity in the pressing direction is obtained by connection of the conductive fine particles in the organic insulating material in the deformed state. In addition, the anisotropic conductive particles are resistant to flaking off of the organic insulating material by friction between adjacent anisotropic conductive particles during circuit connection, and can ensure the insulating property between adjacent circuits, allowing generation of shorts to be adequately inhibited. Furthermore, the anisotropic conductive particles undergo deformation by pressure during circuit connection, thus allowing conductivity to be obtained between opposing circuits through the conductive fine particles. Consequently, the circuit connecting material comprising the anisotropic conductive particles can both ensure insulation between adjacent circuits in high-definition circuits, and ensure conductivity between opposing circuits.

The invention further provides a circuit connecting material situated between mutually opposing circuit electrodes, which provides electrical connection between electrodes in the pressing direction when mutually opposing circuit electrodes are pressed, the circuit connecting material comprising anisotropic conductive particles wherein the resistance after 50% flattening from the particle diameter, upon application of pressure, is no greater than 1/100 of the resistance before application of the pressure. According to this circuit connecting material, which comprises anisotropic conductive particles that satisfy the aforementioned condition, it is possible to both ensure insulation between adjacent circuits in a high-definition circuit, and ensure conductivity between opposing circuits.

The anisotropic conductive particles preferably comprise conductive fine particles dispersed in an organic insulating material. The anisotropic conductive particles in the circuit connecting material, having conductive fine particles dispersed in an organic insulating material, are resistant to flaking off of the organic insulating material by friction between adjacent anisotropic conductive particles during circuit connection, and can ensure the insulating property between adjacent circuits, allowing generation of shorts to be adequately inhibited. Furthermore, the anisotropic conductive particles undergo deformation by pressure during circuit connection, thus allowing conductivity to be obtained between opposing circuits through the conductive fine particles. Consequently, the circuit connecting material comprising the anisotropic conductive particles can both ensure insulation between adjacent circuits in high-definition circuits, and ensure conductivity between opposing circuits.

The anisotropic conductive particles preferably comprise 20-300 parts by volume of the conductive fine particles dispersed in 100 parts by volume of the organic insulating material. The circuit connecting material comprising anisotropic conductive particles having such a structure can more adequately both ensure insulation between adjacent circuits and ensure conductivity between opposing circuits.

The mean particle size of the conductive fine particles in the anisotropic conductive particles is preferably 0.0002-0.6 times the mean particle size of the anisotropic conductive particles. The circuit connecting material comprising anisotropic conductive particles having such a construction can more adequately both ensure insulation between adjacent circuits and ensure conductivity between opposing circuits.

The maximum particle size of the conductive fine particles in the anisotropic conductive particles is preferably no greater than 0.9 times the mean particle size of the anisotropic conductive particles. The circuit connecting material comprising anisotropic conductive particles having such a structure can more adequately ensure insulation between adjacent circuits.

The conductive fine particles in the anisotropic conductive particles are preferably particles composed of a carbon material. The carbon material is preferably graphite or carbon nanotubes. The circuit connecting material comprising anisotropic conductive particles having such a structure can more adequately both ensure insulation between adjacent circuits and ensure conductivity between opposing circuits.

The conductive fine particles in the anisotropic conductive particles are also preferably particles composed of a metal material. The metal material is preferably silver or gold. Particles composed of these metal materials have low resistivity and allow sufficiently low connection resistance to be obtained with small amounts.

The shapes of the conductive fine particles in the anisotropic conductive particles are preferably scaly or needle-like. Conductive fine particles with scaly or needle-like shapes have greater surface area for the same volume, compared to spherical particles, elliptical particles or globular particles, and can provide sufficiently low connection resistance in smaller usage amounts.

The conductive fine particles in the anisotropic conductive particles preferably have hydrophobic-treated surfaces. Hydrophobic treatment of the surfaces of the conductive fine particles can increase the bonding strength between the organic insulating material and the conductive fine particles of the anisotropic conductive particles.

The anisotropic conductive particles preferably have a mean particle size of 0.5-30 µm. The circuit connecting material comprising anisotropic conductive particles having such a structure can more adequately both ensure insulation between adjacent circuits and ensure conductivity between opposing circuits.

Preferably, the circuit connecting material further comprises (1) an epoxy resin and (2) an epoxy resin curing agent, or (3) a radical-polymerizing substance and (4) a curing agent that generates free radicals by heat or light. If the circuit connecting material comprises these components it will be possible to obtain satisfactory bonding strength between circuit members that are to be connected.

The invention further provides a film-like circuit connecting material comprising a circuit connecting material of the invention that has been formed into a film. Such a film-like circuit connecting material, which comprises a circuit connecting material of the invention, can both ensure insulation between adjacent circuits in a high-definition circuit, and ensure conductivity between opposing circuits. The film-like circuit connecting material is easy to manage since it is formed into a film.

The invention further provides a structure for connecting a circuit member, comprising a first circuit member with a first connecting terminal and a second circuit member with a second connecting terminal, disposed with the first connecting terminal and second connecting terminal mutually opposing each other, wherein a circuit-connecting member comprising a cured circuit-connecting material of the invention is situated between the mutually opposing first connecting terminal and second connecting terminal, and the mutually opposing first connecting terminal and second connecting terminal are electrically connected. Since the circuit-connecting member in this structure for connecting a circuit member comprises a cured circuit-connecting material of the invention, insulation between adjacent circuits (connecting terminals) and conductivity between opposing circuits (connecting terminals) are adequately ensured, and excellent connection reliability can be obtained.

In this structure for connecting a circuit member, at least one circuit member of the first circuit member and second circuit member preferably comprises a connecting terminal having a surface composed of at least one selected from the group consisting of gold, silver, tin and platinum group metals. This can further ensure insulation between adjacent circuits while reducing connection resistance between opposing circuits.

In this structure for connecting a circuit member, at least one circuit member of the first circuit member and second circuit member preferably comprises a connecting terminal having a surface composed of a transparent electrode made of indium-tin oxide. This can further ensure insulation between adjacent circuits while reducing connection resistance between opposing circuits.

In at least one circuit member of the first circuit member and second circuit member, the board supporting the connecting terminal is preferably composed of at least one material selected from the group consisting of polyester terephthalates, polyethersulfones, epoxy resins, acrylic resins, polyimide resins and glass. This will allow the bonding strength to be further increased between the circuit member having a board with such a construction, and the circuit-connecting member.

In at least one circuit member of the first circuit member and second circuit member, the side that contacts with the circuit-connecting member is preferably coated with at least one type of material selected from the group consisting of silicone compounds, polyimide resins and acrylic resins. Alternatively, in at least one circuit member of the first circuit member and second circuit member, at least one type of material selected from the group consisting of silicone compounds, polyimide resins and acrylic resins is preferably attached to the side that contacts with the circuit-connecting member. This can further improve the bonding strength between the circuit-connecting member and the side that has been coated with the material or has the material attached thereto.

The invention further provides a method for connecting a circuit member, wherein a first circuit member with a first connecting terminal and a second circuit member with a second connecting terminal are disposed with the first connecting terminal and second connecting terminal mutually opposing each other, and a circuit connecting material of the invention is situated between the mutually opposed first connecting terminal and second connecting terminal and the stack is heated and pressed to electrically connect the mutually opposed first connecting terminal and second connecting terminal. Since a circuit connecting material of the invention is used in this method for connecting a circuit member, it is possible to form a structure for connecting a circuit member which has adequately ensured insulation between adjacent circuits (connecting terminals) and conductivity between opposing circuits (connecting terminals), and excellent connection reliability.

In this method for connecting a circuit member, at least one circuit member of the first circuit member and second circuit member preferably comprises a connecting terminal having a surface composed of at least one selected from the group consisting of gold, silver, tin and platinum group metals. This can further ensure insulation between adjacent circuits while reducing connection resistance between opposing circuits.

In this method for connecting a circuit member, at least one circuit member of the first circuit member and second circuit member preferably comprises a connecting terminal having a surface composed of a transparent electrode made of indium-tin oxide. This can further ensure insulation between adjacent circuits while reducing connection resistance between opposing circuits.

In at least one circuit member of the first circuit member and second circuit member, the board supporting the connecting terminal is preferably composed of at least one material selected from the group consisting of polyester terephthalates, polyethersulfones, epoxy resins, acrylic resins, polyimide resins and glass. This will allow the bonding strength to be further increased between the circuit members that are to be connected.

In at least one circuit member of the first circuit member and second circuit member, the side that contacts with the circuit connecting material is preferably coated with at least one type of material selected from the group consisting of silicone compounds, polyimide resins and acrylic resins. Alternatively, in at least one circuit member of the first circuit member and second circuit member, at least one type of material selected from the group consisting of silicone compounds, polyimide resins and acrylic resins is preferably attached to the side that contacts with the circuit connecting material. This will allow the bonding strength to be further increased between the circuit members that are to be connected.

### Advantageous Effects of Invention

According to the invention, it is possible to provide a circuit connecting material can both ensure insulation between adjacent circuits of a high-definition circuit and ensure conductivity between opposing circuits, as well as a film-like circuit connecting material using it. According to the invention it is also possible to provide a structure for connecting a circuit member which, by employing a circuit connecting material of the invention, both ensures insulation between adjacent circuits in a high-definition circuit and ensures conductivity between opposing circuits, and has excellent connection reliability, as well as a method for connecting a circuit member that can form the structure for connecting a circuit member.

### Brief Description of Drawings

Fig. 1 is a schematic cross-sectional view showing a preferred embodiment of anisotropic conductive particles used in a circuit connecting material of the invention.
Fig. 2 is a simplified cross-sectional view showing an embodiment of a structure for connecting a circuit member according to the invention.
Fig. 3 is a process drawing in a simplified cross-sectional view showing an embodiment of a method for connecting a circuit member according to the invention.

### Description of Embodiments

Preferred embodiments of the invention will now be explained in detail, with reference to the accompanying drawings as necessary. However, the present invention is not limited to the embodiments described below. Identical or corresponding parts in the drawings will be referred to by like reference numerals and will be explained only once. Also, the dimensional proportions depicted in the drawings are not necessarily limitative.

### (Anisotropic conductive particles)

The anisotropic conductive particles used for the circuit connecting material of the invention have two independent features. The first feature is that the conductive fine particles are dispersed in an organic insulating material. The second feature is that the resistance after 50% flattening from the particle diameter, upon application of pressure to the anisotropic conductive particles, is no greater than 1/100 of the resistance of the anisotropic conductive particles before application of pressure.

The material, material quality, composition and production method are not particularly restricted, so long as the resistance after 50% flattening from the particle diameter, upon application of pressure to the anisotropic conductive particles, is no greater than 1/100 of the resistance of the anisotropic conductive particles before application of pressure, according to this second feature. This value is appropriately selected according to the degree of definition of the connecting circuit when they are to be used as a circuit connecting material, but it is more preferably no greater than 1/1000, especially preferably no greater than 1/10,000 and most preferably no greater than 1/100,000, from the viewpoint of more adequately obtaining both conductivity between opposing circuits and insulation between adjacent circuits, in high-definition circuits.

The phrase "resistance after 50% flattening from the particle diameter" means the resistance in the pressing direction, when pressure is applied to the anisotropic conductive particles and the thickness in the pressing direction has been deformed to 50% with respect to the thickness before pressing. When the anisotropic conductive particles have non-spherical shapes as described hereunder, the pressing direction is the direction of minimum thickness,

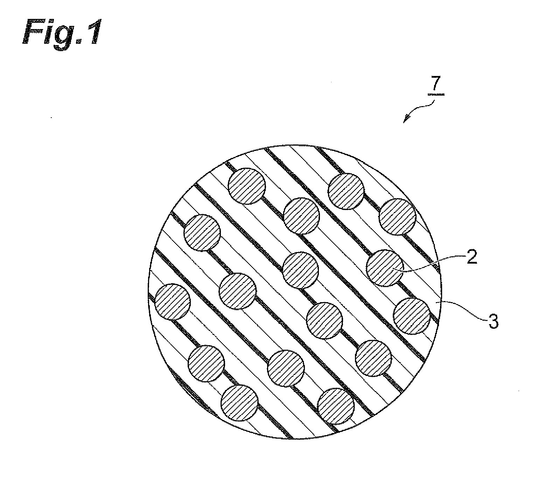

Fig. 1 is a schematic cross-sectional view showing a preferred embodiment of anisotropic conductive particles used in a circuit connecting material of the invention. The anisotropic conductive particles 7 of this embodiment are composed of an organic insulating material 3 and conductive fine particles 2 dispersed in the organic insulating material 3.

The anisotropic conductive particles 7 may be obtained by using the organic insulating material 3 as a binder and dispersing therein a prescribed amount of the conductive fine particles 2. Examples for the organic insulating material 3 include styrene resins, acrylic resins, silicone resins, polyimides, polyurethanes, polyamideimides, polyesters and the like.

The organic insulating material 3 may also be an organic-inorganic composite insulating material.

The anisotropic conductive particles 7 can also be provided by particles composed mainly of compounds having planar molecular structures and conjugated π electron orbitals perpendicular thereto, such as aromatic liquid crystal compounds, aromatic polycyclic compounds, phthalocyanines, naphthalocyanines and high-molecular-weight derivatives of these compounds.

The anisotropic conductive particles 7 may be obtained, for example, by suspension polymerization or pearl polymerization, wherein the starting monomer for the organic insulating material 3 and a curing agent are dispersed in water, with dispersion of a prescribed amount of conductive fine particles 2 together therewith in the polymerization system.

They may also be obtained by curing a dispersion of the conductive fine particles 2 in the starting monomer for the organic insulating material 3 by heat or ultraviolet rays, and pulverizing and classifying the cured product to obtain particles of the desired size.

Alternatively, they may be obtained by dispersing the conductive fine particles 2 in the starting monomer for the organic insulating material 3, forming a film using a coating machine or the like, pulverizing the film obtained by reacting the monomer by heat, ultraviolet rays or the like, and obtaining particles of the desired size by classification.

In addition, they may be obtained by melting the organic insulating material 3 or dissolving it in a solvent, dispersing a prescribed amount of conductive fine particles 2 therein, forming a film using a coating machine or the like, pulverizing the film obtained by reacting the monomer by heat, ultraviolet rays or the like, and obtaining particles of the desired size by classification.

When the conductive fine particles 2 that are used are magnetic bodies, a magnetic field may be applied in the vertical direction during film formation using a magnet or the like, for orientation of the conductive fine particles 2 in the vertical direction.

The mean particle size of the anisotropic conductive particles 7 is preferably 0.5-30 µm. The mean particle size is appropriately selected according to the degree of definition of the connecting circuit when the anisotropic conductive particles are to be used as a circuit connecting material, but it is more preferably 1-20 µm, from the viewpoint of conductivity between opposing circuits and insulation between adjacent circuits, in high-definition circuits. When the state of connection between the opposing circuits is to be confirmed by the flatness of the anisotropic conductive particles 7, the mean particle size is most preferably 2-10 µm from the viewpoint of visibility, for observation carried out with a microscope.

The mean particle size of the anisotropic conductive particles 7 is obtained by measuring the particle sizes of the individual particles with a microscope and determining the average (of 100 measurements).

The organic insulating material 3 used for the invention is preferably a material having an insulation resistance of 1 × 10⁸ Ω/cm or greater as measured under conditions of 25°C, 70% RH. The insulation resistance may be measured using a common insulation resistance meter, for example.

The organic insulating material 3 may be, for example, an organic insulating material such as a styrene resin, acrylic resin, silicone resin, polyimide, polyurethane, polyamideimide or polyester, an organic-inorganic composite insulating material, or a copolymer of the foregoing. These materials have a proven record of use in the prior art as starting materials for circuit connecting materials, and may be suitably used. They may be used alone or in combinations of two or more.

A common electric conductor may be used in the material of the conductive fine particles 2. Examples of materials for the conductive fine particles 2 include carbon materials such as graphite, carbon nanotubes, mesophase carbon, amorphous carbon, carbon black, carbon fiber, fullerene and carbon nanohorns, and metal materials such as platinum, silver, copper and nickel. Of these, graphites such as graphite or carbon nanotubes are preferred from the viewpoint of economical production. On the other hand, precious metals such as gold, platinum, silver and copper are preferred because they have low resistivity and can yield low connection resistance in small amounts. These conductive fine particles 2 are also preferred because of their ready availability on market. The conductive fine particles 2 composed of silver are available, for example, under the 3000 Series or SP Series product name by Mitsui Mining & Smelting Co., Ltd. The conductive fine particles 2 composed of copper are available, for example, under the 1000Y Series, 1000N Series, MA-C Series, 1000YP Series, T Series or MF-SH Series product name by Mitsui Mining & Smelting Co., Ltd. The conductive fine particles 2 composed of platinum are available, for example, under the AY-1000 Series product name by Tanaka Holdings Co., Ltd. The conductive fine particles 2 composed of graphite are available, for example, under the AT Series product name by Oriental Sangyo Co., Ltd. The conductive fine particles 2 composed of carbon nanotubes are available, for example, under the Carbere product name by GSI Creos Corp., and the VGCF Series product name by Showa Denko K.K. The conductive fine particles 2 composed of carbon black are available, for example, under the #3000 Series product name by Mitsubishi Chemical Corp. Most other carbon materials are available from Mitsubishi Chemical Corp., Nippon Carbon Co., Ltd. or Hitachi Chemical Co., Ltd. These may be used alone or in combinations of two or more.

The conductive fine particles 2 that are used may have the surface layer coated with a different metal, or the surfaces of the resin fine particles may be coated with a metal or the like.

The conductive fine particles 2 used in the anisotropic conductive particles 7 can easily exhibit their function by dispersion at 20-300 parts by volume with respect to 100 parts by volume of the organic insulating material 3. The amount of the conductive fine particles 2 is more preferably 30-250 parts by volume and especially preferably 50-150 parts by volume. If the amount of conductive fine particles 2 is less than 20 parts by volume, the resistance of the flattened anisotropic conductive particles 7 will tend to be higher. If it exceeds 300 parts by volume, the resistance of the anisotropic conductive particles 7 before application of pressure will tend to be lowered, and the insulation between adjacent circuits upon circuit connection may be reduced as a result.

The shapes of the conductive fine particles 2 are not particularly restricted, and for example, they may be amorphous (having an undefined shape, or consisting of a mixture of particles of various shapes), spherical, elliptical spherical, globular, scaly, flaky, tabular, needle-like, filamentous or bead-like. Conductive fine particles 2 with scaly or needle-like shapes have greater surface area for the same volume, compared to spherical particles, elliptical particles or globular particles, and are therefore preferred for obtaining the same effect with smaller usage amounts. These may be used alone or in combinations of two or more.

The mean particle size of the conductive fine particles 2 is preferably 0.0002-0.6 times, more preferably 0.001-0.5 times and most preferably 0.01-0.5 times the mean particle size of the anisotropic conductive particles 7. If the mean particle size of the conductive fine particles 2 is less than 0.0002 times the mean particle size of the obtained anisotropic conductive particles 7, it may be difficult to lower the resistance of the anisotropic conductive particles 7 during pressing. If it is greater than 0.6 times, the conductive fine particles 2 will tend to fly off from the surfaces of the anisotropic conductive particles 7, thus tending to lower the resistance of the anisotropic conductive particles 7 before application of pressure and potentially lowering the insulation between adjacent circuits during circuit connection.

The maximum particle size of the conductive fine particles 2 is preferably no greater than 0.9 times and more preferably no greater than 0.8 times the mean particle size of the anisotropic conductive particles 7. If the maximum particle size of the conductive fine particles 2 is greater than 0.9 times the mean particle size of the obtained anisotropic conductive particles 7, the conductive fine particles 2 will tend to fly off from the surfaces of the anisotropic conductive particles 7, thus tending to lower the resistance of the anisotropic conductive particles 7 before application of pressure and potentially lowering the insulation between adjacent circuits during circuit connection.

When the shape of a conductive fine particle 2 is any shape other than spherical, the particle size of the conductive fine particle 2 is the diameter of the smallest sphere that circumscribes the conductive fine particle 2.

The mean particle size and maximum particle size of the conductive fine particles 2 are obtained by measuring the particle sizes of the individual particles with a microscope and determining the average (of 100 measurements).

According to the invention, conductive fine particles 2 with hydrophobic-treated surfaces may be used. Hydrophobic treatment of the surfaces of the conductive fine particles 2 is preferred as it can increase the bonding strength between the conductive fine particles 2 and the organic insulating material 3 of the anisotropic conductive particles 7. Also, when the anisotropic conductive particles 7 are produced by a method for producing particles from oil droplets in an aqueous layer, such as suspension polymerization or emulsion polymerization, the conductive fine particles 2 can be selectively added to the oil droplets, thereby increasing production yield.

The hydrophobic treatment may be, for example, coupling agent treatment, or surface treatment of the conductive fine particles 2 with a sulfur atom-containing organic compound or nitrogen atom-containing organic compound.

The coupling agent treatment may involve, for example, impregnating the conductive fine particles 2 with a solution comprising a prescribed amount of coupling agent dissolved in a solvent capable of dissolving the coupling agent. In this case, the coupling agent content in the solution is preferably 0.01 mass%-5 mass% and more preferably 0.1 mass%-1.0 mass% with respect to the entire solution.

The coupling agent used may be, for example, a silane-based coupling agent, aluminum-based coupling agent, titanium-based coupling agent or zirconium-based coupling agent, with silane-based coupling agents being preferred for use. The silane-based coupling agent is preferably one having a functional group such as epoxy, amino, mercapto, imidazole, vinyl or methacryl in the molecule. These may be used alone or in combinations of two or more.

The solvent used for preparation of such silane-based coupling agent solutions may be, for example, water, an alcohol or a ketone. A small amount of an acid such as acetic acid or hydrochloric acid, for example, may also be added to promote hydrolysis of the coupling agent.

The conductive fine particles 2 that have been treated with the silane-based coupling agent may be dried by natural drying, heat drying or vacuum drying, for example. Depending on the type of coupling agent used, the drying may be preceded by rinsing or ultrasonic cleaning.

Examples of the sulfur atom-containing organic compounds and the nitrogen atom-containing organic compounds include sulfur atom-containing compounds such as mercapto, sulfide and disulfide compounds, and compounds including one or more nitrogen atom-containing organic compounds that have groups such as -N=, -N=N- or -NH₂ in the molecule. These may be used in addition to an acidic solution, alkaline solution or coupling agent solution. They may be used alone or in combinations of two or more.

Examples of the sulfur atom-containing organic compounds include aliphatic thiols represented by the following formula (I):

HS-(CH₂)ₙ-R (I)

(wherein n is an integer of 1-23, and R represents a monovalent organic group, hydrogen or a halogen atom),
thiazole derivatives (thiazole, 2-aminothiazole, 2-aminothiazole-4-carboxylic acid, aminothiophene, benzothiazole, 2-mercaptobenzothiazole, 2-aminobenzothiazole, 2-amino-4-methylbenzothiazole, 2-benzothiazolol, 2,3-dihydroimidazo[2,1-b]benzothiazole-6-amine, ethyl 2-(2-aminothiazol-4-yl)-2-hydroxyiminoacetate, 2-methylbenzothiazole, 2-phenylbenzothiazole, 2-amino-4-methylthiazole and the like), thiadiazole derivatives (1,2,3-thiadiazole, 1,2,4-thiadiazole, 1,2,5-thiadiazole, 1,3,4-thiadiazole, 2-amino-5-ethyl-1,3,4-thiadiazole, 5-amino-1,3,4-thiadiazole-2-thiol, 2,5-mercapto-1,3,4-thiadiazole, 3-methylmercapto-5-mercapto-1,2,4-thiadiazole, 2-amino-1,3,4-thiadiazole, 2-(ethylamino)-1,3,4-thiadiazole, 2-amino-5-ethylthio-1,3,4-thiadiazole and the like), mercaptobenzoic acid, mercaptonaphthol, mercaptophenol, 4-mercaptobiphenyl, mercaptoacetic acid, mercaptosuccinic acid, 3-mercaptopropionic acid, thiouracil, 3-thiourazole, 2-thiouramil, 4-thiouramil, 2-mercaptoquinoline, thioformic acid, 1-thiocoumarin, thiocoumothiazone, thiocresol, thiosalicylic acid, thiocyanuric acid, thionaphthol, thiotolene, thionaphthene, thionaphthenecarboxylic acid, thionaphthenequinone, thiobarbituric acid, thiohydroquinone, thiophenol, thiophene, thiophthalide, thiophthene, thiolthionecarbonic acid, thiolutidone, thiolhistidine, 3-carboxypropyl disulfide, 2-hydroxyethyl disulfide, 2-aminopropionic acid, dithiodiglycolic acid, D-cysteine, di-t-butyl disulfide, thiocyan and thiocyanic acid. These may be used alone or in combinations of two or more.

In formula (I) which represents an aliphatic thiol, R is preferably a monovalent organic group such as amino, amide, carboxyl, carbonyl or hydroxyl, for example, but there is no limitation to these, and it may be, for example, a C1-18 alkyl, C1-8 alkoxy, acyloxy or haloalkyl group, a halogen atom, hydrogen, thioalkyl, thiol, optionally substituted phenyl, biphenyl, naphthyl or a heterocyclic ring. The monovalent organic group may have a single amino group, amide, carboxyl or hydroxyl group, but it preferably has more than one and more preferably more than two such groups. The other monovalent organic groups mentioned above may be optionally substituted with alkyl or the like.

In formula (I) representing an aliphatic thiol group, n is an integer of 1-23, more preferably an integer of 4-15 and most preferably an integer of 6-12.

Examples of the nitrogen atom-containing organic compounds include triazole derivatives (1H-1,2,3-triazole, 2H-1,2,3-triazole, 1H-1,2,4-triazole, 4H-1,2,4-triazole, benzotriazole, 1-aminobenzotriazole, 3-amino-5-mercapto-1,2,4-triazole, 3-amino-1H-1,2,4-triazole, 3,5-diamino-1,2,4-triazole, 3-oxy-1,2,4-triazole, aminourazole and the like), tetrazole derivatives (tetrazolyl, tetrazolylhydrazine, 1H-1,2,3,4-tetrazole, 2H-1,2,3,4-tetrazole, 5-amino-1H-tetrazole, 1-ethyl-1,4-dihydroxy-5H-tetrazol-5-one, 5-mercapto-1-methyltetrazole, tetrazolemercaptane and the like), oxazole derivatives (oxazole, oxazolyl, oxazoline, benzooxazole, 3-amino-5-methylisooxazole, 2-mercaptobenzooxazole, 2-aminooxazoline, 2-aminobenzooxazole and the like), oxadiazole derivatives (1,2,3-oxadiazole, 1,2,4-oxadiazole, 1,2,5-oxadiazole, 1,3,4-oxadiazole, 1,2,4-oxadiazolone-5, 1,3,4-oxadiazolone-5 and the like), oxatriazole derivatives (1,2,3,4-oxatriazole, 1,2,3,5-oxatriazole and the like), purine derivatives (purine, 2-amino-6-hydroxy-8-mercaptopurine, 2-amino-6-methylmercaptopurine, 2-mercaptoadenine, mercaptohypoxanthine, mercaptopurine, uric acid, guanine, adenine, xanthine, theophylline, theobromine, caffeine and the like), imidazole derivatives (imidazole, benzimidazole, 2-mercaptobenzimidazole, 4-amino-5-imidazolecarboxylic acid amide, histidine and the like), indazole derivatives (indazole, 3-indazolone, indazolol and the like), pyridine derivatives (2-mercaptopyridine, aminopyridine and the like), pyrimidine derivatives (2-mercaptopyrimidine, 2-aminopyrimidine, 4-aminopyrimidine, 2-amino-4,6-dihydroxypyrimidine, 4-amino-6-hydroxy-2-mercaptopyrimidine, 2-amino-4-hydroxy-6-methylpyrimidine, 4-amino-6-hydroxy-2-methylpyrimidine, 4-amino-6-hydroxypyrazolo[3,4-d]pyrimidine, 4-amino-6-mercaptopyrazolo[3,4-d]pyrimidine, 2-hydroxypyrimidine, 4-mercapto-1H-pyrazolo[3,4-d]pyrimidine, 4-amino-2,6-dihydroxypyrimidine, 2,4-diamino-6-hydroxypyrimidine, 2,4,6-triaminopyrimidine and the like), thiourea derivatives (thiourea, ethylenethiourea, 2-thiobarbituric acid and the like), amino acids (glycine, alanine, tryptophan, proline, oxyproline and the like), 1,3,4-thiooxadiazolone-5, thiocoumazone, 2-thiocoumarin, thiosaccharin, thiohydantoin, thiopyrine, γ-thiopyrine, guanadine, guanazole, guanamine, oxazine, oxadiazine, melamine, 2,4,6-triaminophenol, triaminobenzene, aminoindole, aminoquinoline, aminothiophenol and aminopyrazole. These may be used alone or in combinations of two or more.

These anisotropic conductive particles 7 falling within the scope of the invention may be used alone or in combinations of two or more, depending on the purpose, and they may also be used in combination with anisotropic conductive particles or conductive particles that are outside the scope of the invention.

### (Circuit connecting material)

The circuit connecting material of the invention is preferably one having the anisotropic conductive particles 7 dispersed in an adhesive composition, from the viewpoint of facilitating production. Examples of adhesive compositions include thermosetting adhesive compositions and photocuring adhesive compositions. Specifically, for example, there may be used adhesive compositions comprising (1) an epoxy resin (hereunder referred to as "component (1)") and (2) an epoxy resin curing agent (hereunder referred to as "component (2)"), adhesive compositions comprising (3) a radical-polymerizing substance (hereunder referred to as "component (3)") and (4) a curing agent that generates free radicals by heat or light (hereunder referred to as "component (4)"), and mixed compositions that include an adhesive composition comprising component (1) and component (2) and an adhesive composition comprising component (3) and component (4).

Examples of the epoxy resins as component (1) include bisphenol A-type epoxy resins, bisphenol F-type epoxy resins, bisphenol S-type epoxy resins, phenol-novolac-type epoxy resins, cresol-novolac-type epoxy resins, bisphenol A-novolac-type epoxy resins, bisphenol F-novolac-type epoxy resins, alicyclic epoxy resins, glycidyl ester-type epoxy resins, glycidylamine-type epoxy resins, hydantoin-type epoxy resins, isocyanurate-type epoxy resins and aliphatic straight-chain epoxy resins. The epoxy resins may also be halogenated or hydrogenated. An acryloyl or methacryloyl group may also be added to a side chain of the epoxy resin. These may be used alone or in combinations of two or more.

The epoxy resin curing agent as component (2) is not particularly restricted so long as it is one capable of curing the epoxy resin, and examples include anionic polymerizable catalyst-type curing agents, cationic polymerizable catalyst-type curing agents and polyaddition-type curing agents. Preferred among these are anionic and cationic polymerizable catalyst-type curing agents since they have excellent fast-curing properties and do not require special consideration in regard to chemical equivalents.

Examples of the anionic or cationic polymerizable catalyst-type curing agents include tertiary amines, imidazole-based curing agents, hydrazide-based curing agents, boron trifluoride-amine complexes, sulfonium salts, amineimides, diaminomaleonitriles, melamine and its derivatives, polyamine salts and dicyandiamides, as well as modified forms of the foregoing.

Examples of the polyaddition-type curing agents include polyamines, polymercaptanes, polyphenols and acid anhydrides.

When a tertiary amine or imidazole, for example, is added as an anionic polymerizable catalyst-type curing agent, the epoxy resin is cured by heating at a moderate temperature of about 160°C-200°C for between several tens of seconds and several hours. This is preferred because it lengthens the pot life.

Photosensitive onium salts that cure epoxy resins under energy ray exposure (mainly aromatic diazonium salts, aromatic sulfonium salts and the like), may also be suitably used as cationic polymerizable catalyst-type curing agents. Also, aliphatic sulfonium salts are among cationic polymerizable catalyst-type curing agents that are activated and cure epoxy resins by heat instead of energy ray exposure. Such curing agents are preferred because of their fast-curing properties.

Latent curing agents that have been microencapsulated by covering these epoxy resin curing agents with polyurethane-based or polyester-based polymer substances or inorganic materials such as metal thin-films of nickel or copper, or calcium silicate, are preferred as they can lengthen the pot life.

For a connection time of up to 25 seconds, the epoxy resin curing agent content is preferably 1-50 parts by mass and more preferably 2-20 parts by mass with respect to 100 parts by mass as the total of the epoxy resin and the film-forming material which is added as necessary, in order to obtain a sufficient reaction rate. If no limit on the connection time can be assumed, the curing agent content is preferably 0.05-10 parts by mass and more preferably 0.1-2 parts by mass with respect to 100 parts by mass as the total of the epoxy resin and the film-forming material which is added as necessary.

These (2) epoxy resin curing agents may be used alone or in combinations of two or more.

Examples of the radical-polymerizing substances that may be used as component (3) include substances having functional groups that polymerize by radicals, without any particular restrictions. Specific (3) radical-polymerizing substances include acrylate (including corresponding methacrylate, same hereunder) compounds, acryloxy (including corresponding methacryloxy, same hereunder) compounds, maleimide compounds, citraconimide resins, nadimide resins and the like. These radical-polymerizing substances may be used as a monomers or oligomers, or monomers and oligomers may be used in combination.

Examples of the acrylate compounds and acryloxy compounds include methyl acrylate, ethyl acrylate, isopropyl acrylate, isobutyl acrylate, ethyleneglycol diacrylate, diethyleneglycol diacrylate, trimethylolpropane triacrylate, tetramethylolmethane tetraacrylate, 2-hydroxy-1,3-diacryloxypropane, 2,2-bis[4-(acryloxymethoxy)phenyl]propane, 2,2-bis[4-(acryloxypolyethoxy)phenyl]propane, dicyclopentenyl acrylate, tricyclodecanyl acrylate, tris(acryloyloxyethyl) isocyanurate and urethane acrylate. If necessary, an appropriate amount of a polymerization inhibitor such as hydroquinone or methyl ether hydroquinone may be used. From the viewpoint of improving the heat resistance, the radical-polymerizing substance, such as an acrylate compound, preferably has at least one substituent selected from the group consisting of dicyclopentenyl, tricyclodecanyl and triazine rings.

Examples of the maleimide compounds include those with at least two maleimide groups in the molecule. Examples of such maleimide compounds include 1-methyl-2,4-bismaleimidebenzene, N,N'-m-phenylenebismaleimide, N,N'-p-phenylenebismaleimide, N,N'-m-toluilenebismaleimide, N,N'-4,4-biphenylenebismaleimide, N,N'-4,4-(3,3'-dimethylbiphenylene)bismaleimide, N,N'-4,4-(3,3'-dimethyldiphenylmethane)bismaleimide, N,N'-4,4-(3,3'-diethyldiphenylmethane)bismaleimide, N,N'-4,4-diphenylmethanebismaleimide, N,N'-4,4-diphenylpropanebismaleimide, N,N'-3,3'-diphenylsulfonebismaleimide, N,N'-4,4-diphenyl etherbismaleimide, 2,2-bis(4-(4-maleimidephenoxy)phenyl)propane, 2,2-bis(3-s-bulyl-4,8-(4-maleimidephenoxy)phenyl)propane, 1,1-bis(4-(4-maleimidephenoxy)phenyl)decane, 4,4'-cyclohexylidene-bis(1-(4-maleimidephenoxy)-2-cyclohexylbenzene and 2,2-bis(4-(4-maleimidephenoxy)phenyl)hexafluoropropane.

The citraconimide resins are, for example, compounds obtained by copolymerizing a citraconimide compound with at least one citraconimide group in the molecule. Examples of such citraconimide compounds include phenylcitraconimide, 1-methyl-2,4-biscitraconimidebenzene, N,N'-m-phenylenebiscitraconimide, N,N'-p-phenylenebiscitraconimide, N,N'-4,4-biphenylenebiscitraconimide, N,N'-4,4-(3,3-dimethylbiphenylene)biscitraconimide, N,N'-4,4-(3,3-dimethyldiphenylmethane)biscitraconimide, N,N'-4,4-(3,3-diethyldiphenylmethane)biscitraconimide, N,N'-4,4-diphenylmethanebiscitraconimide, N,N'-4,4-diphenylpropanebiscitraconimide, N,N'-4,4-diphenyl etherbiscitraconimide, N,N'-4,4-diphenylsulfonebiscitraconimide, 2,2-bis(4-(4-citraconimidephenoxy)phenyl)propane, 2,2-bis(3-s-butyl-3,4-(4-citraconimidephenoxy)phenyl)propane, 1,1-bis(4-(4-citraconimidephenoxy)phenyl)decane, 4,4'-cyclohexylidene-bis(1-(4-citraconimidephenoxy)phenoxy)-2-cyclohexylbenzene and 2,2-bis(4-(4-citraconimidephenoxy)phenyl)hexafluoropropane.

The nadimide resins are compounds obtained by copolymerizing a nadimide compound with at least one nadimide group in the molecule. Examples of the nadimide compounds include phenylnadimide, 1-methyl-2,4-bisnadimidebenzene, N,N'-m-phenylenebisnadimide, N,N'-p-phenylenebisnadimide, N,N'-4,4-biphenylenebisnadimide, N,N'-4,4-(3,3-dimethylbiphenylene)bisnadimide, N,N'-4,4-(3,3-dimethyldiphenylmethane)bisnadimide, N,N'-4,4-(3,3-diethyldiphenylmethane)bisnadimide, N,N'-4,4-diphenylmethanebisnadimide, N,N'-4,4-drphenylpropanebisnadimide, N,N'-4,4-diphenyl etherbisnadimide, N,N'-4,4-diphenylsulfonebisnadimide, 2,2-bis(4-(4-nadimidephenoxy)phenyl)propane, 2,2-bis(3-s-butyl-3,4-(4-nadimidephenoxy)phenyl)propane, 1,1-bis(4-(4-nadimidephenoxy)phenyl)decane, 4,4'-cylohexylidene-bis(1-(4-nadimidephenoxy)phenoxy)-2-cyclohexylbenzene and 2,2-bis(4-(4-nadimidephenoxy)phenyl)hexafluoropropane.

The (3) radical-polymerizing substance is also preferably a combination of a radical-polymerizing substance having a phosphoric acid ester structure represented by the following formula (II), used together with the other radical-polymerizing substance. This will improve the adhesive strength with respect to inorganic material surfaces such as metals, thus rendering the circuit suitable for bonding between circuit electrodes.

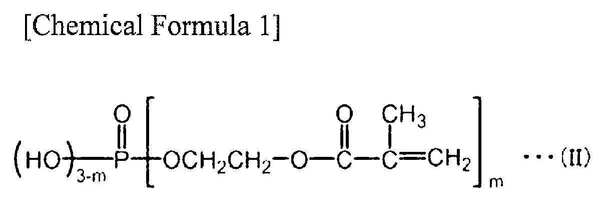

(In the formula, m is an integer of 1-3.)

The radical-polymerizing substance with a phosphoric acid ester structure may be obtained, for example, by reaction between phosphoric anhydride and 2-hydroxyethyl (meth)acrylate. Specific examples include mono(2-methacryloyloxyethyl)acid phosphate and di(2-methacryloyloxyethyl)acid phosphate.

The content of the radical-polymerizing substance with a phosphoric acid ester structure represented by formula (II) above is preferably 0.01-50 parts by mass and more preferably 0.5-5 parts by mass with respect to 100 parts by mass as the total of the other radical-polymerizing substances and the film-forming material that is added as necessary.

The radical-polymerizing substance may also be used together with allyl acrylate. In such cases, the allyl acrylate content is preferably 0.1-10 parts by mass and more preferably 0.5-5 parts by mass with respect to 100 parts by mass as the total of the radical-polymerizing substance and the film-forming material that is added as necessary.

These radical-polymerizing substances may be used alone or in combinations of two or more.

The (4) curing agent that generates free radicals by heat or light may be used without any particular restrictions so long as it is a curing agent that generates free radicals by decomposition under irradiation by heating or electromagnetic waves, such as ultraviolet rays. Specific examples include peroxide compounds and azo-based compounds. Such curing agents may be appropriately selected as appropriate for the desired connection temperature, connection time and pot life. From the standpoint of achieving both high reactivity and a long pot life, an organic peroxide with a 10 hour half-life temperature of 40°C or higher and a 1 minute half-life temperature of no higher than 180°C is preferred, and an organic peroxide with a 10 hour half-life temperature of 60°C or higher and a 1 minute half-life temperature of no higher than 170°C is more preferred.

Curing agents that generate free radicals by heating include, more specifically, diacyl peroxides, peroxy dicarbonates, peroxy esters, peroxy ketals, dialkyl peroxides, hydroperoxides and silyl peroxides. Preferred among these are peroxy esters, dialkyl peroxides, hydroperoxides and silyl peroxides, and more preferably peroxy esters with high reactivity.

Examples of the peroxy esters include cumylperoxy neodecanoate, 1,1,3,3-tetramethylbutylperoxy neodecanoate, 1-cyclohexyl-1-methylethylperoxy neodecanoate, t-hexylperoxy neodecanoate, t-butylperoxy pivalate, 1,1,3,3-tetramethylbutylperoxy-2-ethyl hexanoate, 2,5-dimethyl-2,5-di(2-ethylhexanoylperoxy)hexane, 1-cyclohexyl-1-methylethylperoxy-2-ethyl hexanoate, t-hexylperoxy-2-ethyl hexanoate, t-butylperoxy-2-ethyl hexanoate, t-butylperoxy isobutyrate, 1,1-bis(t-butylperoxy)cyclohexane, t-hexylperoxyisopropyl monocarbonate, t-butylperoxy-3,5,5-trimethyl hexanoate, t-butylperoxy laurate, 2,5-dimethyl-2,5-di(m-toluoylperoxy)hexane, t-butylperoxyisopropyl monocarbonate, t-butylperoxy-2-ethylhexyl monocarbonate, t-hexylperoxybenzoate and t-butylperoxy acetate.

Examples of the dialkyl peroxides include α,α'-bis(t-butylperoxy)diisopropylbenzene, dicumyl peroxide, 2,5-dimethyl-2,5-di(t-butylperoxy)hexane and t-butylcumyl peroxide.

Examples of the hydroperoxides include diisopropylbenzene hydroperoxide and cumene hydroperoxide.

Examples of the silyl peroxides include t-butyltrimethylsilyl peroxide, bis(t-butyl)dimethylsilyl peroxide, t-butyltrivinylsilyl peroxide, bis(t-butyl)divinylsilyl peroxide, tris(t-butyl)vinylsilyl peroxide, t-butyltriallylsilyl peroxide, bis(t-butyl)diallylsilyl peroxide and tris(t-butyl)allylsilyl peroxide.

Examples of the diacyl peroxides include isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide.

Examples of the peroxy dicarbonates include di-n-propylperoxy dicarbonate, diisopropylperoxy dicarbonate, bis(4-t-butylcyclohexyl)peroxy dicarbonate, di-2-ethoxymethoxyperoxy dicarbonate, di(2-ethylhexylperoxy)dicarbonate, dimethoxybutylperoxy dicarbonate and di(3-methyl-3-methoxybutylperoxy) dicarbonate.

Examples of the peroxy ketals include 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1, 1-(t-butylperoxy)cyclododecane and 2,2-bis(t-butylperoxy)decane.

From the viewpoint of inhibiting corrosion of the circuit electrodes, the curing agent preferably has a chloride ion or organic acid concentration of no greater than 5000 ppm in the curing agent. More preferably, the amount of organic acid generated after thermolysis is low.

These curing agents that generate free radicals by heat or light may be used in admixture with triggers or inhibitors, for example. The curing agents are preferably used in microencapsulated form by coating with a polyurethane-based or polyester-based macromolecular compound, to impart a latent property. Microencapsulated curing agents are preferred for a longer pot life.

For a connection time of up to 25 seconds, the content of the curing agent that generates free radicals by heat or light is approximately 2-10 parts by mass and more preferably 4-8 parts by mass with respect to 100 parts by mass as the total of the radical-polymerizing substance and the film-forming material which is added as necessary, in order to obtain a sufficient reaction rate. If no limit on the connection time can be assumed, the curing agent content is preferably 0.05-20 parts by mass and more preferably 0.1-10 parts by mass with respect to 100 parts by mass as the total of the radical-polymerizing substance and the film-forming material which is added as necessary.

The curing agent that generates free radicals by heat or light is used either alone or in combinations oftwo or more.

A film-forming material may also be added to the circuit connecting material of this embodiment, as necessary. A film-forming material is a material which, when a liquid substance is solidified and the composition for the circuit connecting material is formed into a film, facilitates handling of the film and confers mechanical properties that prevent tearing, cracking or sticking, thereby permitting it to be handled as a film under ordinary conditions (ordinary temperature and pressure). Examples of such film-forming materials include phenoxy resins, polyvinyl formal resins, polystyrene resins, polyvinyl butyral resins, polyester resins, polyamide resins, xylene resins, polyurethane resins and the like. Phenoxy resins are preferred among these because of their excellent adhesion, compatibility, heat resistance and mechanical strength.

A phenoxy resin is a resin obtained by, for example, reacting a bifunctional phenol with an epihalohydrin until polymerization, or by polyaddition of a bifunctional epoxy resin and a bifunctional phenol. Specifically, for example, the phenoxy resin may be obtained by reacting 1 mol of a bifunctional phenol with 0.985-1.015 mol of an epihalohydrin in a non-reactive solvent at a temperature of 40-120°C, in the presence of a catalyst such as an alkali metal hydroxide. From the viewpoint of resin mechanical properties and thermal properties, particularly preferred phenoxy resins are those obtained by polyaddition reaction of a bifunctional epoxy resin and a bifunctional phenol at an epoxy group/phenolic hydroxyl group equivalent ratio of 110.9-111.1, with heating to 50-200°C under conditions with a reaction solid content of no greater than 50 mass%, in an organic solvent such as an amide-based, ether-based, ketone-based, lactone-based or alcohol-based solvent with a boiling point of 1.20°C or higher, in the presence of a catalyst such as an alkali metal compound, organic phosphorus-based compound, cyclic amine-based compound or the like.

Examples of the bifunctional epoxy resins include bisphenol A-type epoxy resin, bisphenol F-type epoxy resin, bisphenol AD-type epoxy resin, bisphenol S-type epoxy resin, biphenyldiglycidyl ether and methyl-substituted biphenyldiglycidyl ether.

Bifunctional phenols have two phenolic hydroxyl groups, and examples include hydroquinones, and bisphenols such as bisphenol A, bisphenol F, bisphenol AD, bisphenol S, bisphenolfluorene, methyl-substituted bisphenolfluorene, dihydroxybiphenyl and methyl-substituted dihydroxybiphenyl. The phenoxy resin may be modified with radical-polymerizing functional groups or with other reactive compounds (for example, epoxy-modified).

The content of the film-forming material, when added to an adhesive composition comprising (1) an epoxy resin and (2) an epoxy resin curing agent, is preferably 5-80 parts by mass and more preferably 20-70 parts by mass, with respect to 100 parts by mass as the total of the epoxy resin and film-forming material, from the viewpoint of the resin flow property during circuit connection.

The content of the film-forming material, when added to an adhesive composition comprising (3) a radical-polymerizing substance and (3) a curing agent that generates free radicals by heat or light, is preferably 5-80 parts by mass and more preferably 20-70 parts by mass, with respect to 100 parts by mass as the total of the radical-polymerizing substance and film-forming material, from the viewpoint of the resin flow property during circuit connection.

These film-forming materials may be used alone or in combinations of two or more.

The circuit connecting material of this embodiment may also contain a polymer or copolymer comprising at least one from among acrylic acid, acrylic acid esters, methacrylic acid esters and acrylonitrile as a monomer component. From the viewpoint of stress relaxation, there are preferred glycidyl acrylates containing glycidyl ether groups, or copolymer-based acrylic rubbers containing glycidyl methacrylate as a monomer component. The weight-average molecular weight of the acrylic rubber is preferably at least 200,000 from the viewpoint of increasing the cohesion of the adhesive.

The content of the anisotropic conductive particles in the circuit connecting material of this embodiment, when they are added to an adhesive composition comprising (1) an epoxy resin and (2) an epoxy resin curing agent, is preferably 0.1-100 parts by volume with respect to 100 parts by volume as the total of the epoxy resin and the film-forming material, and it is more preferably 0.5-40 parts by volume and most preferably 1-20 parts by volume, from the viewpoint of conductivity between opposing circuits and insulation between adjacent circuits, upon circuit connection.

Also, the content of the anisotropic conductive particles in the circuit connecting material of this embodiment, when they are added to an adhesive composition comprising (3) a radical-polymerizing substance and (4) a curing agent that generates free radicals by heat or light, is preferably 0.5-100 parts by volume with respect to 100 parts by volume as the total of the radical-polymerizing substance and the film-forming material, and it is more preferably 1-40 parts by volume and most preferably 1-20 parts by volume, from the viewpoint of conductivity between opposing circuits and insulation between adjacent circuits, upon circuit connection.

The circuit connecting material of this embodiment may also contain rubber fine particles or a filler, softening agent, accelerator, age inhibitor, coloring agent, flame retardant, thixotropic agent, coupling agent, phenol resin, melamine resin, isocyanate or the like, as necessary.

The rubber fine particles have a mean particle size of preferably no greater than twice the mean particle size of the anisotropic conductive particles to be added, and the storage elastic modulus at room temperature (25°C) is preferably no greater than 1/2 the storage elastic modulus of the anisotropic conductive particles and the adhesive composition at room temperature. Suitable examples for the material of such rubber fine particles include silicone, an acrylic emulsion, SBR, NBR or polybutadiene rubber. Three-dimensionally crosslinked rubber fine particles have excellent solvent resistance and excellent dispersibility in adhesive compositions.

A filler is preferably included in the circuit connecting material to improve the connection reliability. The filler is preferably one having a maximum diameter that is no greater than 1/2 the mean particle size of the anisotropic conductive particles. When using nonconductive particles in combination therewith, it is suitable to use particles having a maximum diameter of no greater than the mean particle size of the anisotropic conductive particles.

Preferred examples of the coupling agents include compounds containing vinyl groups, acrylic groups, epoxy groups or isocyanate groups, from the viewpoint of increasing adhesion.

The conductive particles that are included in the circuit connecting material of the invention as necessary are not particularly restricted so long as they have conductivity that permits electrical connection to be established. Examples of such conductive particles include metallic particles such as Au, Ag, Ni, Cu or solder, or carbon particles. The conductive particles may consist of nucleus particles covered with one or more layers, with a conductive outermost layer covering them. The conductive particles may comprise insulating particles of plastic or the like as nuclei, and a layer composed mainly of the aforementioned metal or carbon covering the surfaces of the nuclei.

These components added as necessary may be used alone or in combinations of two or more.

The circuit connecting material of the invention may be used in paste form if it is a liquid at ordinary temperature. When it is a solid at ordinary temperature, it may be heated into a paste, or dissolved in a solvent to form a paste. The solvent used is not particularly restricted so long as it does not react with the circuit connecting material and exhibits sufficient solubility, but it preferably has a boiling point of 50-150°C at ordinary pressure, and examples include organic solvents such as toluene and acetone. If the boiling point of the solvent used is below 50°C, the solvent will readily volatilize at room temperature, tending to interfere with manageability during subsequent film fabrication. If the boiling point is above 150°C, it will be difficult to volatilize off the solvent, and sufficient bonding strength will tend to be difficult to achieve after bonding. These solvents may be used as single compounds or as combinations of two or more compounds.

The circuit connecting material of the invention may also be used after its shaping into a film. The film-like circuit connecting material can be obtained by coating a support substrate with a mixture comprising a solvent or the like added to the circuit connecting material, or impregnating a substrate such as a nonwoven fabric with the mixture and placing it on a support substrate, and then removing the solvent. Forming the circuit connecting material into a film in this manner provides the additional advantage of excellent handleability.

The support substrate used is preferably a sheet or film. The support substrate may also be in the form of a stack of 2 or more layers. Support substrates include polyethylene terephthalate (PET) films, orientated polypropylene (OPP) films, polyethylene (PE) films and polyimide films. PET films are preferred among these from the viewpoint of increasing dimensional precision and lowering cost.

The circuit connecting material may also be used as a circuit connecting material for different types of adherends with different thermal expansion coefficients.

### (Structure for connecting a circuit member)

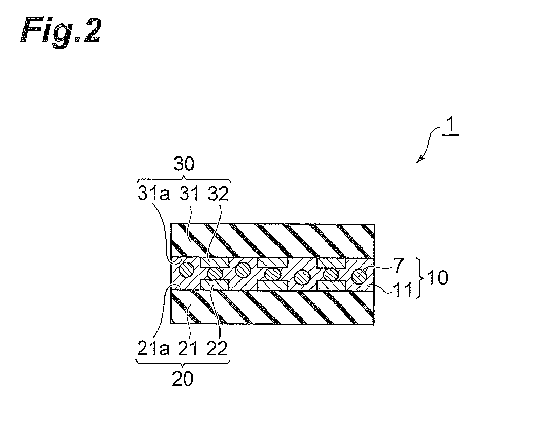

Fig. 2 is a simplified cross-sectional view showing an embodiment of a structure for connecting a circuit member according to the invention. The structure for connecting a circuit member 1, shown in Fig. 2, comprises a first circuit member 20 and a second circuit member 30 which are mutually opposing, and a circuit-connecting member 10 is formed between the first circuit member 20 and second circuit member 30 and connects them.

The first circuit member 20 comprises a first circuit board 21 and a first connecting terminal 22 formed on the main side 21a of the first circuit board 21. The second circuit member 30 comprises a second circuit board 31 and a second connecting terminal 32 formed on the main side 31a of the second circuit board 31. An insulating layer (not shown) may also be formed on the main side 21a of the first circuit board 21 and/or on the main side 31 a of the second circuit board 31. That is, the insulating layer that is formed as necessary is formed between the circuit-connecting member 10 and either or both the first circuit member 20 and second circuit member 30.

The first and second circuit boards 21, 31 may be boards composed of an inorganic material such as a semiconductor, glass or ceramic, an organic material such as a polyimide resin, a polycarbonate, a polyester terephthalate such as polyethylene terephthalate, a polyethersulfone, epoxy resin, acrylic resin or the like, typical for TCP, FPC, COF and the like, or a composite material comprising such inorganic materials or organic materials. From the viewpoint of further increasing the bonding strength with the circuit-connecting member 10, either or both the first and second circuit board is preferably a board composed of a material comprising at least one resin selected from the group consisting of polyester terephthalates, polyethersulfones, epoxy resins, acrylic resins, polyimide resins, and glass.

When an insulating layer is coated on or attached to the surface of the circuit member in contact with the circuit-connecting member 10, the insulating layer is preferably a layer comprising at least one resin selected from the group consisting of silicone resins, acrylic resins and polyimide resins. This will further improve the bonding strength between the first circuit board 21 and/or second circuit board 31 and the circuit-connecting member 10, compared to when no insulating layer has been formed.

Either or both the first connecting terminal 22 and second connecting terminal 32 preferably has a surface comprising a material containing at least one substance selected from the group consisting of gold, silver, tin and platinum group metals and indium-tin oxide. This will allow the resistance value of the opposing connecting terminals 22 and 32 to be further reduced while maintaining insulation between adjacent connecting terminals 22 and 32 on the same circuit member 20 or 30.

Specific examples for the first and second circuit members 20, 30 include glass panels or plastic boards on which connecting terminals made of ITO (indium-tin oxide) or the like are formed for use in liquid crystal display devices, printed circuit boards, ceramic circuit boards, flexible circuit boards, semiconductor silicon chips and the like. These may be used in combinations if necessary.

The circuit-connecting member 10 is formed from a cured circuit-connecting material of the invention that comprises anisotropic conductive particles 7. The circuit-connecting member 10 comprises an insulating material 11, and anisotropic conductive particles 7 dispersed in the insulating material 11. The anisotropic conductive particles 7 in the circuit-connecting member 10 are situated not only between each opposing first connecting terminal 22 and second connecting terminal 32, but also between the main sides 2 1 a and 31a. In the structure for connecting a circuit member 1, the anisotropic conductive particles 7 are in direct contact with both the first and second connecting terminals 22, 32, while being compressed into a flat shape between the first and second connecting terminals 22, 32. The first and second connecting terminals 22, 32 are therefore electrically connected via the anisotropic conductive particles 7. Consequently, connection resistance between the first connecting terminal 22 and second connecting terminal 32 is adequately reduced. As a result, smooth current flow can be achieved between the first and second connecting terminals 22, 32, to allow the function of the circuit to be adequately exhibited.

Since the circuit-connecting member 10 is constructed of the cured circuit-connecting material described below, the adhesive force of the circuit-connecting member 10 for the first circuit member 20 and second circuit member 30 is sufficiently high.

### (Method for connecting structure for connecting a circuit member)

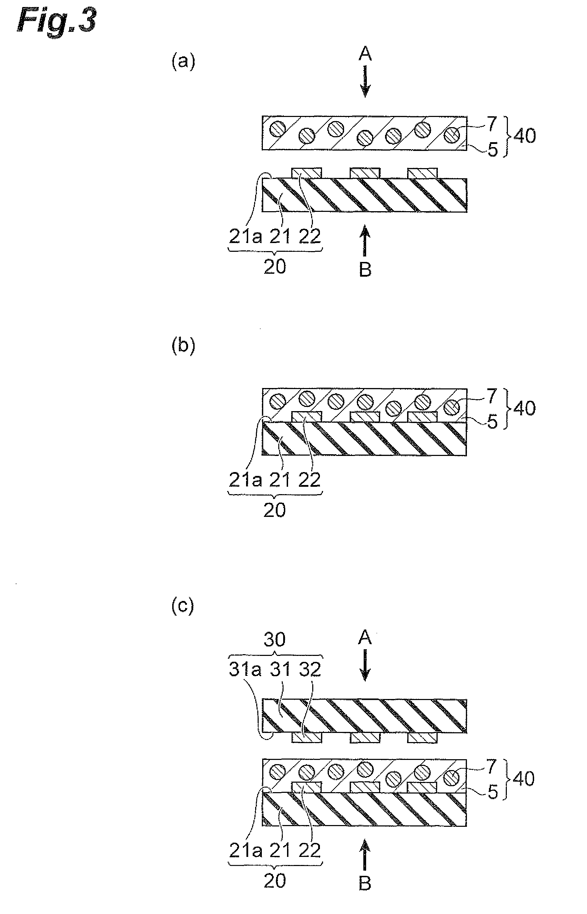

Figs. 3(a)-(c) are process drawings in a simplified cross-sectional view showing an embodiment of a method for connecting a circuit member according to the invention.

For this embodiment, the aforementioned first circuit member 20 and a film-like circuit connecting material 40 are first prepared.

The thickness of the circuit connecting material 40 is preferably 5-50 µm. If the thickness of the circuit connecting material 40 is less than 5 µm, the circuit connecting material 40 will tend to fail to sufficiently fill the area between the first and second connecting terminals 22, 32. If the thickness is greater than 50 µm, on the other hand, it will tend to be difficult to ensure conduction between the first and second connecting terminals 22, 32.

The film-like circuit connecting material 40 is then placed over the side of the first circuit member 20 on which the connecting terminal 22 has been formed. The film-like circuit connecting material 40 is pressed in the direction of the arrows A and B in Fig. 3(a) to provisionally join the film-like circuit connecting material 40 with the first circuit member 20 (Fig. 3(b)).

The pressure used for this procedure is generally preferred to be 0.1-30 MPa, although it is not particularly restricted so long as it is in a range that does not damage the circuit member. The pressure may be applied while heating, and the heating temperature should be a temperature that essentially does not cause hardening of the circuit connecting material 40. The heating temperature is usually preferred to be 50-190°C. The heating and pressing are preferably carried out for a period in the range of 0.5-120 seconds.

Next, as shown in Fig. 3(c), the second circuit member 30 is placed on the film-like circuit connecting material 40 with the second connecting terminal 32 facing the first circuit member 20 side. When the film-like circuit connecting material 40 is formed by attachment onto a support substrate (not shown), the second circuit member 30 is placed on the film-like circuit connecting material 40 after releasing the support substrate. The entire circuit connecting material 40 is pressed in the direction of the arrows A and B in Fig. 3(c) while heating.

The heating temperature is, for example, 90-200°C, and the connecting time is, for example, 1 second-10 minutes. The conditions for the procedure may be appropriately selected according to the purpose of use, the circuit connecting material and the circuit member, and postcuring may also be performed if necessary. For example, when the circuit connecting material is to contain a radical polymerizing compound, the heating temperature is a temperature that allows generation of radicals by the radical polymerization initiator. This will cause the radical polymerization initiator to generate radicals to initiate polymerization of the radical polymerizing compound.

Heating of the film-like circuit connecting material 40 hardens the film-like circuit connecting material 40 with a sufficiently small distance between the first connecting terminal 22 and second connecting terminal 32, thus forming a strong joint between the first circuit member 20 and second circuit member 30 via the circuit-connecting member 10.

Curing of the film-like circuit connecting material 40 forms a circuit-connecting member 10, to obtain a structure for connecting a circuit member 1 as shown in Fig. 2. The conditions for joining may be appropriately selected depending on the purpose of use, the circuit connecting material and the circuit member.

According to this embodiment, the anisotropic conductive particles 7 can contact with both of the opposing first and second connecting terminals 22, 32 in the obtained structure for connecting a circuit member 1, and it is possible to sufficiently reduce connection resistance between the first and second connecting terminals 22, 32 while also allowing insulation between adjacent first and second connecting terminals 22, 32 to be adequately ensured. Furthermore, since the circuit-connecting member 10 is constructed of the cured circuit-connecting material described above, the adhesive force of the circuit-connecting member 10 for the first and second circuit member 20 or 30 is sufficiently high.

### Examples

Preferred examples of the invention will now be described, with the understanding that these examples are in no way limitative on the invention.

### <Production Example 1: Preparation of anisotropic conductive particles 1>

### [Preparation of conductive fine particles]

Scaly silver powder 1 having a particle size distribution of 0.005-10 µm was obtained by a chemical reduction method. The obtained silver powder 1 was classified to obtain scaly silver powder 2 having a mean particle size of 0.25 µm and a maximum particle size of 0.4 µm.

### [Preparation of anisotropic conductive particles]

The starting monomer for an organic insulating material was prepared by mixing 60 parts by mass of tetramethylolmethane triacrylate, 20 parts by mass of divinylbenzene and 20 parts by mass of acrylonitrile. Also, silver powder 2 was added at 120 parts by volume to 100 parts by volume of the starting monomer for the organic insulating material, and a bead mill was used for dispersion of the silver powder for 48 hours. After mixing 2 parts by mass of benzoyl peroxide with the silver powder-dispersed composition, the mixture was loaded into 850 parts by mass of a 3 mass% polyvinyl alcohol aqueous solution and thoroughly stirred, after which it was suspended with a homogenizer until the polymerizable monomer droplets formed fine particulates with particle sizes of approximately 0.4-33 µ, to obtain a suspension. The obtained suspension was transferred to a 2 liter separable flask equipped with a thermometer, stirrer and reflux condenser, and the temperature was raised to 85°C while stirring in a nitrogen atmosphere for 7 hours of polymerization reaction, after which the temperature was raised to 90°C and maintained for 3 hours to complete the polymerization reaction. The polymerization reaction solution was then cooled, and the produced particles were filtered out and thoroughly rinsed with water and dried to obtain anisotropic conductive particles having a particle size of 0.4-33 µm. The obtained anisotropic conductive particles were classified to obtain anisotropic conductive particles 1 with a mean particle size of 5.55 µm comprising silver fine particles.

### <Production Example 2: Preparation of anisotropic conductive particles 2>

The silver powder 2 prepared in Production Example 1 was impregnated with a solution of 3 parts by mass of N-(2-aminoethyl)-3-aminopropyltrimethoxysilane in 100 parts by mass of methyl ethyl ketone, and stirring was carried out for one day and night for hydrophobic treatment of the silver powder surface. Anisotropic conductive particles 2 were obtained in the same manner as Production Example 1, except for using this silver powder with a hydrophobic-treated surface.

### <Production Example 3: Preparation of anisotropic conductive particles 3>

The anisotropic conductive particles prepared in Production Example 1 were classified to obtain anisotropic conductive particles 3 having a mean particle size of 0.5 µm.

### <Production Example 4: Preparation of anisotropic conductive particles 4>

The anisotropic conductive particles prepared in Production Example 1 were classified to obtain anisotropic conductive particles 4 having a mean particle size of 30 µm.

### <Production Example 5: Preparation of anisotropic conductive particles 5>

Anisotropic conductive particles 5 were obtained in the same manner as Production Example 1, except that the content of the silver powder 2 used in Production Example 1 was 20 parts by volume.

### <Production Example 6: Preparation of anisotropic conductive particles 6>

Anisotropic conductive particles 6 were obtained in the same manner as Production Example 1, except that the content of the silver powder 2 used in Production Example 1 was 300 parts by volume.

### <Production Example 7: Preparation of anisotropic conductive particles 7>

The silver powder 1 used in Production Example 1 was classified to obtain scaly silver powder 3 having a mean particle size of 0.01 µm and a maximum particle size of 0.03 µm. Anisotropic conductive particles 7 were obtained in the same manner as Production Example 1, except for using this silver powder 3.

### <Production Example 8: Preparation of anisotropic conductive particles 8>

The silver powder 1 used in Production Example 1 was classified to obtain scaly silver powder 4 having a mean particle size of 3.3 µm and a maximum particle size of 4.95 µm. Anisotropic conductive particles 8 were obtained in the same manner as Production Example 1, except for using this silver powder 4.

### <Production Example 9: Preparation of anisotropic conductive particles 9>

Anisotropic conductive particles 9 were obtained in the same manner as Production Example 1, except that amorphous graphite having a mean particle size of 3 µm and a maximum particle size of 4 µm was used in the conductive fine particles.

### <Production Example 10: Preparation of anisotropic conductive particles 10>

Anisotropic conductive particles 10 were obtained in the same manner as Production Example 1, except that needle-like graphite having a mean particle size of 3 µm and a maximum particle size of 4 µm was used in the conductive fine particles.

### <Production Example 11: Preparation of anisotropic conductive particles 11>

Anisotropic conductive particles 11 were obtained in the same manner as Production Example 1, except that spherical gold having a mean particle size of 1 µm and a maximum particle size of 2 µm was used in the conductive fine particles.

### <Production Example 12: Preparation of anisotropic conductive particles 12>

After adding 120 parts by volume of silver powder 2 to 100 parts by volume of a silicone resin (KR-242A, product of Shin-Etsu Chemical Co., Ltd.), a bead mill was used for dispersion of the silver powder for 48 hours. There was further added 1 part by mass of the polymerization catalyst CAT-AC (product of Shin-Etsu Chemical Co., Ltd.) to 100 parts by mass of the silicone resin, and the mixture was stirred for 10 minutes. The obtained conductive fine particle-dispersing silicone resin was coated onto a PET film using a coating apparatus and dried with hot air at 120°C for 1 hour, to obtain a film-like conductive fine particle-dispersing silicone resin with a thickness of 50 µm. The obtained film-like conductive fine particle-dispersing silicone resin was pulverized and then classified to obtain anisotropic conductive particles 12 having a mean particle size of 5 µm.

### <Production Example 13: Preparation of anisotropic conductive particles 13>

Anisotropic conductive particles 13 were obtained in the same manner as Production Example 1, except that the content of the silver powder 2 used in Production Example 1 was 10 parts by volume.

### <Production Example 14: Preparation of anisotropic conductive particles 14>

Anisotropic conductive particles 14 were obtained in the same manner as Production Example 1, except that the content of the silver powder 2 used in Production Example 1 was 400 parts by volume.

### <Production Example 15: Preparation of anisotropic conductive particles 15>

The silver powder 1 used in Production Example 1 was classified to obtain scaly silver powder 5 having a mean particle size of 3.9 µm and a maximum particle size of 5.5 µm. Anisotropic conductive particles 15 were obtained in the same manner as Production Example 1, except for using this silver powder 5.

### <Production Example 16: Preparation of conductive particles>

Conductive particles, which were resin particles coated with nickel and gold (product name: Micropearl AU, by Sekisui Chemical Co., Ltd.) were prepared.

### <Production Example 17: Preparation of insulating particle-coated conductive particles>

### [Preparation of insulating particles]

In a 1000 mL-volume separable flask on which a 4-necked separable cover, stirring blade, three-way cock, condenser tube and temperature probe were mounted, a monomer composition comprising 100 mmol of methyl methacrylate, 1 mmol of N,N,N-trimethyl-N-2-methacryloyloxyethylammonium chloride and 1 mmol of 2,2'-azobis(2-amidinopropane) dihydrochloride was added to distilled water to a solid content of 5 mass%, and the mixture was stirred at 200 rpm, for polymerization under a nitrogen atmosphere at 70°C for 24 hours. Upon completion of the reaction, the mixture was freeze-dried to obtain insulating particles with a mean particle size of 220 nm, having ammonium groups on the surface.

### [Preparation of metal surface particles]

Core particles composed of tetramethylolmethane tetraacrylateldivinylbenzene copolymer with a mean particle size of 5 µm were subjected to degreasing, sensitizing and activating to produce Pd nuclei on the resin surface, to form catalyst nuclei for electroless plating. Next, the particles with catalyst nuclei were dipped in a prepared, heated electroless Ni plating bath according to a prescribed method to form a Ni plating layer. The nickel layer surface was then subjected to electroless substitution gold plating to obtain metal surface particles. The Ni plating thickness on the obtained metal surface particles was 90 nm, and the gold plating thickness was 30 nm.

### [Preparation of insulating particle-coated conductive particle]

The insulating particles were dispersed in distilled water under ultrasonic irradiation, to obtain a 10 mass% aqueous dispersion of insulating particles. After dispersing 10 g of the metal surface particles in 500 mL of distilled water, 4 g of the aqueous dispersion of insulating particles was added and the mixture was stirred at room temperature (25°C) for 6 hours. After filtration with a 3 µm mesh filter, it was further rinsed with methanol and dried to obtain insulating particle-coated conductive particles.

### <Production Example 18: Preparation of insulating resin-coated conductive particles>

The metal surface particles of Comparative Example 2 were added to and stirred with a 1 mass% dimethylformamide (DMF) solution of PARAPRENE P-25M (thermoplastic polyurethane resin, softening point: 130°C, trade name of Nippon Elastran Co., Ltd.). Next, the obtained dispersion was subjected to spray-drying at 100°C for 10 minutes using a spray drier (Model GA-32 by Yamato Scientific Co., Ltd.), to obtain insulating resin-coated conductive particles. The average thickness of the covering layer comprising the insulating resin was approximately 1 µm according to cross-sectional observation with an electron microscope (SEM).

### (Example 1)

After mixing 50 g of a bisphenol A-type epoxy resin, 20 g of a bisphenol F-type epoxy resin and, as an epoxy resin latent curing agent, 30 g of a microencapsulated curing agent with a mean particle size of 5 µm, comprising an imidazole-modified compound as nuclei and having the surfaces covered with polyurethane, anisotropic conductive particles 1 were mixed and dispersed therein to 5 parts by volume with respect to 100 parts by volume of the epoxy resin component, to obtain a circuit connecting material 1.

### (Example 2)

There was dissolved 50 g of a phenoxy resin (trade name: PKHC, product of Union Carbide Corp., weight-average molecular weight: 45,000) in a mixed solvent of toluene/ethyl acetate = 50/50 as the mass ratio, to prepare a solution with a solid content of 40 mass%. After mixing 20 g of the aforementioned phenoxy resin, 30 g of a bisphenol A-type epoxy resin and, as an epoxy resin latent curing agent, 30 g of a microencapsulated curing agent with a mean particle size of 5 µm, comprising an imidazole-modified compound as nuclei and having the surfaces covered with polyurethane, as solid mass ratio, anisotropic conductive particles 1 were mixed and dispersed therein to 5 parts by volume with respect to 100 parts by volume as the total of the epoxy resin component and the film-forming material component, to obtain a paste-like circuit connecting material. A coating apparatus was used to coat the paste-like circuit connecting material onto a 80 µm-thick PET (polyethylene terephthalate) film surface-treated on one side, and the coating was dried with hot air at 70°C for 10 minutes to obtain a film-like circuit connecting material 2 with a layer thickness of 20 µm, composed of the circuit connecting material.

### (Example 3)

A film-like circuit connecting material 3 was obtained in the same manner as Example 2, except for using the anisotropic conductive particles 2.

### (Example 4)

A film-like circuit connecting material 4 was obtained in the same manner as Example 2, except for using the anisotropic conductive particles 3.

### (Example 5)

A film-like circuit connecting material 5 was obtained in the same manner as Example 2, except for using the anisotropic conductive particles 4.

### (Example 6)

A film-like circuit connecting material 6 was obtained in the same manner as Example 2, except for using the anisotropic conductive particles 5.

### (Example 7)

A film-like circuit connecting material 7 was obtained in the same manner as Example 2, except for using the anisotropic conductive particles 6.

### (Example 8)

A film-like circuit connecting material 8 was obtained in the same manner as Example 2, except for using the anisotropic conductive particles 7.

### (Example 9)

A film-like circuit connecting material 9 was obtained in the same manner as Example 2, except for using the anisotropic conductive particles 8.

### (Example 10)

A film-like circuit connecting material 10 was obtained in the same manner as Example 2, except for using the anisotropic conductive particles 9.

### (Example 11)

A film-like circuit connecting material 11 was obtained in the same manner as Example 2, except for using the anisotropic conductive particles 10.

### (Example 12)

A film-like circuit connecting material 12 was obtained in the same manner as Example 2, except for using the anisotropic conductive particles 11.

### (Example 13)

A film-like circuit connecting material 13 was obtained in the same manner as Example 2, except for using the anisotropic conductive particles 12.

### (Example 14)

A film-like circuit connecting material 14 was obtained in the same manner as Example 2, except that the amount of anisotropic conductive particles 1 used was 0.1 part by volume.

### (Example 15)

A film-like circuit connecting material 15 was obtained in the same manner as Example 2, except that the amount of anisotropic conductive particles 1 used was 100 parts by volume.

### (Example 16)

There were combined 400 parts by mass of polycaprolactonediol with a weight-average molecular weight of 800, 131 parts by mass of 2-hydroxypropyl acrylate, 0.5 part by mass of dibutyltin dilaurate as a catalyst and 1.0 part by mass of hydroquinonemonomethyl ether as a polymerization inhibitor, while stirring and heating at 50°C. Next, 222 parts by mass of isophorone diisocyanate was added dropwise and the temperature was raised to 80°C while stirring for urethanation reaction. Upon confirming at least a 99% isocyanate group reaction rate, the temperature was lowered to obtain urethane acrylate.

After combining 50 g of a phenoxy resin (trade name: PKHC, product of Union Carbide Corp., weight-average molecular weight: 45,000), 49 g of the obtained urethane acrylate, 1 g of a phosphoric acid ester-type acrylate and, as a curing agent that generates free radicals by heat, 5 g of t-hexylperoxy-2-ethyl hexanoate, as solid mass ratio, there was added and dispersed therein 5 parts by volume of anisotropic conductive particles 1 with respect to 100 parts by volume as the total of the radical-polymerizing substance component and film-forming material component, to obtain a paste-like circuit connecting material. A coating apparatus was used to coat the paste-like circuit connecting material onto a 80 µm-thick PET (polyethylene terephthalate) film surface-treated on one side, and the coating was dried with hot air at 70°C for 10 minutes to obtain a film-like circuit connecting material 16 with a layer thickness of 20 µm, composed of the circuit connecting material.

### (Example 17)

A film-like circuit connecting material 17 was obtained in the same manner as Example 2, except for using the anisotropic conductive particles 13.

### (Example 18)

A film-like circuit connecting material 18 was obtained in the same manner as Example 2, except for using the anisotropic conductive particles 14.

### (Example 19)

A film-like circuit connecting material 19 was obtained in the same manner as Example 2, except for using the anisotropic conductive particles 15.

### (Example 20)

A film-like circuit connecting material 20 was obtained in the same manner as Example 2, except that the amount of anisotropic conductive particles 1 used was 0.05 part by volume.

### (Example 21)

A film-like circuit connecting material 21 was obtained in the same manner as Example 2, except that the amount of anisotropic conductive particles used was 150 parts by volume.

### (Comparative Example 1)

A film-like circuit connecting material 22 was obtained in the same manner as Example 2, except that the conductive particles prepared in Production Example 16 were used instead of the anisotropic conductive particles 1.

### (Comparative Example 2)

A film-like circuit connecting material 23 was obtained in the same manner as Example 2, except that the insulating particle-coated conductive particles prepared in Production Example 17 were used instead of the anisotropic conductive particles 1.

### (Comparative Example 3)

A film-like circuit connecting material 24 was obtained in the same manner as Example 2, except that the insulating resin-coated conductive particles prepared in Production Example 18 were used instead of the anisotropic conductive particles 1.

### <Measurement of resistance of anisotropic conductive particles and conductive particles>

A microcompression tester (Model PCT-200 by Shimadzu Corp.) was used for measurement of the anisotropic conductive particles 1-15, the conductive particles prepared in Production Example 16, the insulating particle-coated conductive particles prepared in Production Example 17 and the insulating resin-coated conductive particles prepared in Production Example 18, to determine the resistance before application of pressure and the resistance after 50% flattening (100 measurements), with gold wire bonded to the indenter and stainless steel table of the microcompression tester, thereby allowing measurement of the resistance between the indenter and the stainless steel table, and the results are shown in Table 1. The results in Table 1 are the average values for the resistance measured for 100 measuring samples.

**[Table 1]**

| | Non-deformed resistance (Ω) | 50% Flattened resistance (Ω) |
|---|---|---|
| Anisotropic conductive particles 1 | >10 × 10⁶ | 19.4 |
| Anisotropic conductive particles 2 | >10 × 10⁶ | 20.3 |
| Anisotropic conductive particles 3 | >10 × 10⁶ | 25.4 |
| Anisatropic conducive particles 4 | >10 × 10⁶ | 17.4 |
| Anisotropic conductive particles 5 | >10 10⁶ | 343 |
| Anisotropic conductive particles 6 | >10 × 10⁶ | 12.3 |
| Anisotropic conductive particles 7 | >10× 10⁶ | 864 |
| Anisotropic conductive particles 8 | >10 × 10⁶ | 16.4 |
| Anisotropic conductive particles 9 | >10 × 10⁶ | 33.3 |
| Anisotropic conductive particles 10 | >10 × 10⁶ | 42.6 |
| Anisotropic conductive particles 11 | >10 × 10⁶ | 10.9 |
| Anisotropic conductive particles 12 | >10 × 10⁶ | 17.8 |
| Anisotropic conductive particles 13 | >10 × 10⁶ | 1.70 × 10⁵ |
| Anisotropic conductive particles 14 | 1033 | 11.6 |
| Anisotropic conductive particles 15 | 33.5 | 9.2 |
| Conductive particles | 10.9 | 9.4 |
| Insulating particle-coated conductive particles | 35.4 | 28.3 |
| Insulating resin-coated conductive particles | >10 × 10⁶ | >10 × 10⁶ |

The anisotropic conductive particles 1-12 all had resistance after 50% flattening from the particle diameter, upon application of pressure, of no greater than 1/100 of the resistance of the anisotropic conductive particles before application of pressure.

Since the amount of conductive fine particles of the anisotropic conductive particles 13 was low, even with 50% flattening, the resistance after 50% flattening was not below 1/100 compared to the non-deformed particles, but it was lower than the conductive particles or insulating particle-coated conductive particles.

With the anisotropic conductive particles 14, the amount of conductive fine particles was too great and the resistance of the non-deformed particles was low, although the 50% flattened resistance was below 1/100 compared to the non-deformed particles.

With the anisotropic conductive particles 15, some of the conductive fine particles flew off from the anisotropic conductive particles, thereby lowering the non-deformed resistance, although the 50% flattened resistance was below 1/100.

The conductive particles prepared in Production Example 16 had a metal plating on the surface and therefore had virtually no difference between the non-deformed resistance and the 50% flattened resistance, which were both low resistance values. The reduction of the 50% flattened resistance to about 10% of the non-deformed resistance is attributed to the wider contact area between the indenter and stainless steel table of the microcompression tester due to flattening.

With the insulating particle-coated conductive particles prepared in Production Example 17, the indenter of the microcompression tester passed into the gaps between the insulating particles attached to the surfaces of the Ni plating particles, directly contacting with the plating layer, and there was virtually no difference between the non-deformed resistance and 50% flattened resistance, with low resistance values for both. The reduction of the 50% flattened resistance to about 20% of the non-deformed resistance is attributed to the wider contact area between the indenter and stainless steel table of the microcompression tester due to flattening.

The insulating resin-coated conductive particles prepared in Production Example 18 had an insulating material uniformly covering the plating layer, and therefore no resistance variation was produced even with 50% flattening of the particles.

The anisotropic conductive particles 13-15 had a resistance variation with 50% flattening that was below 1/100 compared to the non-defonned particles, but since a large resistance variation was obtained in comparison between the conductive particles, insulating particle-coated conductive particles and insulating resin-coated conductive particles, they are suitable for practical use, depending on the purpose.

### <Fabrication of structures for connecting circuit members, for measurement of connection resistance>

A flexible circuit board (FPC) having a 3-layer construction comprising a polyimide, an adhesive for bonding of copper foil to the polyimide, and a copper foil with a thickness of 18 µm, with a line width of 30 µm and a pitch of 100 µm, and an ITO substrate (surface resistance <20 Ω/sq.) having a transparent electrode comprising indium-tin oxide (ITO) formed by vapor deposition on 1.1 mm-thick glass, were hot pressed at 180°C, 3 MPa for 10 seconds, for connection across a 1 mm width, using the aforementioned circuit connecting materials 1-24, to obtain structures for connecting circuit members. For use of the film-like circuit connecting materials 2-24, first the adhesive side of each circuit connecting material was attached onto the ITO substrate, and then hot pressed at 70°C, 0.5 MPa for 5 seconds for temporary connection, after which the PET film was released and connected to another FPC. For use of the circuit connecting material 1, a dispenser was used for coating onto the ITO substrate, and after drying at 70°C for 10 minutes, it was connected to another FPC.

### <Measurement of connection resistance>

After connection of the circuit, the resistance values between the ITO substrate and the opposing circuits of the FPCs were measured using a multimeter, initially and after holding for 1000 hours in a high-temperature, high-humidity vessel at 85°C, 85% RH. Each resistance value was expressed as the average of 150 resistance points between the opposing circuits. The results are shown in Table 2.

### <Fabrication of structures for connecting circuit members, for measurement of insulation resistance between adjacent circuits>

For circuit connection, PET fibers with 10 µm diameters and 10 mm lengths were attached to a flexible circuit board using a pincette so as to create bridges between adjacent circuits, and the flexible circuit board and soda glass were connected using each of circuit connecting materials 1-24 by hot pressing at 180°C, 3 MPa for 10 seconds across a width of 2 mm, to obtain a structure for connecting a circuit member. This resulted in connection and aggregation of the anisotropic conductive particles or conductive particles along the PET fibers between adjacent circuits. For use of the film-like circuit connecting materials 2-24, first the adhesive side of the circuit connecting material was attached onto the soda glass, and then hot pressed at 70°C, 0.5 MPa for 5 seconds for temporary connection, after which the PET film was released and connected to another FPC. For use of the circuit connecting material 1, a dispenser was used for coating onto the soda glass, and after drying at 70°C for 10 minutes, it was connected to another FPC.

### <Evaluation of insulation between adjacent circuits>

After circuit connection, the resistance value between the adjacent circuits of the FPCs comprising the connected sections was measured using a multimeter, initially and after holding for 1000 hours in a high-temperature, high-humidity vessel at 85°C, 85% RH. A short was defined as a measured point with a measured resistance of no greater than 1 × 10⁸, and the number of measured points determined to be shorts were counted among 150 measured resistance points between the adjacent circuits. The results are shown in Table 2.

**[Table 2]**

| Evaluation No. | Connection resistance measurement results (Ω) | | Insulating resistance measurement results (Ω) | |
|---|---|---|---|---|
| | Initial | After high-temperature, high-humidity test treatment | Initial | After high-temperature, high-humidity test treatment |
| Example 1 | 1.8 | 3.2 | 0/150 | 0/150 |
| Example 2 | 2.5 | 4.8 | 0/150 | 0/150 |
| Example 3 | 2.6 | 5.0 | 0/150 | 0/150 |
| Example 4 | 2.8 | 5.4 | 0/150 | 0/150 |
| Example 5 | 2.1 | 4.3 | 0/150 | 0/150 |
| Example 6 | 8.4 | 18.6 | 0/150 | 0/150 |
| Example 7 | 1.7 | 2.7 | 0/150 | 0/150 |
| Example 8 | 10.3 | 25.6 | 0/150 | 0/150 |
| Example 9 | 1.9 | 3.3 | 0/150 | 0/150 |
| Example 10 | 3.0 | 5.8 | 0/150 | 0/150 |
| Example 11 | 3.1 | 6.0 | 0/150 | 0/150 |
| Example 12 | 1.6 | 3.0 | 0/150 | 0/150 |
| Example 13 | 2.0 | 3.6 | 0/150 | 0/150 |
| Example 14 | 3.6 | 6.4 | 0/150 | 0/150 |
| Example 15 | 1.3 | 2.4 | 0/150 | 0/150 |
| Example 16 | 2.8 | 5.1 | 0/150 | 0/150 |
| Example 17 | 45.3 | 62.5 | 0/150 | 0/150 |
| Example 18 | 1.7 | 2.8 | 3/150 | 7/150 |
| Example 19 | 2.0 | 4.4 | 5/150 | 9/150 |
| Example 20 | 20.4 | 88.3 | 0/150 | 0/150 |
| Example 21 | 1.1 | 2.0 | 2/150 | 8/150 |
| Comp. Ex. 1 | 1.1 | 3.5 | 90/150 | 120/150 |
| Comp. Ex. 2 | 1.3 | 4.3 | 18/150 | 40/150 |
| Comp. Ex. 3 | >100 | >100 | 0/150 | 0/150 |

Examples 1-16 exhibited satisfactory connection resistance and insulation resistance, as well as satisfactory properties initially and after high-temperature, high-humidity testing.

Example 17 had a low amount of conductive fine particles in the anisotropic conductive particles, and therefore the initial connection resistance in particular was high, but satisfactory insulation resistance was obtained.

Example 18 had an excessive amount of conductive fine particles in the anisotropic conductive particles, and therefore shorts occurred by connection of particles between adjacent electrodes, but satisfactory connection resistance was obtained.

In Example 19, a portion of the conductive fine particles flew off from the anisotropic conductive particles, and therefore shorts occurred by connection of particles between adjacent electrodes, but satisfactory connection resistance was obtained.

Example 20 had a small amount of anisotropic conductive particles and therefore the connection resistance after high-temperature, high-humidity testing in particular was high, but satisfactory insulation resistance was obtained.

In Example 21, the amount of anisotropic conductive particles was excessive and the particles obstructed the spaces between adjacent electrodes, and therefore flattening of the particles and shorts occurred even between adjacent electrodes, but satisfactory connection resistance was obtained.

In Comparative Example 1, the conductive particles were not treated for improved insulation, and therefore numerous shorts occurred.

In Comparative Example 2, the insulating particle-coated conductive particles impacted and rubbed together during circuit connection, causing the insulating particles attached to the surfaces of the Ni plating particles to fall off and causing shorts.

In Comparative Example 3, the insulating resin-coated conductive particles used had an insulating material uniformly covering the plating layer, and therefore the connection resistance was high.

In Examples 18, 19 and 21, shorts occurred under the conditions of the test, but since the number of shorts was less than 1/3 compared to the conductive particles and insulating particle-coated conductive particles, they were suitable for practical use, depending on the purpose.

Examples 17 and 20 had higher connection resistance than Examples 1-16 under the conditions of the test, but lower connection resistance was obtained, compared to insulating resin-coated conductive particles, and they are therefore suitable for practical use, depending on the purpose.

### Industrial Applicability

As explained above, it is possible according to the invention to provide a circuit connecting material can both ensure insulation between adjacent circuits of a high-definition circuit and ensure conductivity between opposing circuits, as well as a film-like circuit connecting material using it. According to the invention it is also possible to provide a structure for connecting a circuit member which, by employing a circuit connecting material of the invention, both ensures insulation between adjacent circuits in a high-definition circuit and ensures conductivity between opposing circuits, and has excellent connection reliability, as well as a method for connecting a circuit member that can form the structure for connecting a circuit member.

### Explanation of Symbols

1: Structure for connecting a circuit member, 2: conductive fine particles, 3: organic insulating material, 5: adhesive component, 7: anisotropic conductive particle, 10: circuit-connecting member, 11: insulating material, 20: first circuit member, 21: first circuit board, 21 a: first circuit board main side, 22: first connecting terminal, 30: second circuit member, 31: second circuit board, 31a: second circuit board main side, 32: second connecting terminal, 40: film-like circuit connecting material, A, B: pressing direction.

## Claims

1. A circuit connecting material situated between mutually opposing circuit electrodes, which provides electrical connection between the electrodes in the pressing direction when the mutually opposing circuit electrodes are pressed,
the circuit connecting material comprising anisotropic conductive particles wherein conductive fine particles are dispersed in an organic insulating material.

2. A circuit connecting material situated between mutually opposing circuit electrodes, which provides electrical connection between electrodes in the pressing direction when mutually opposing circuit electrodes are pressed,
the circuit connecting material comprising anisotropic conductive particles wherein the resistance after 50% flattening from the particle diameter, upon application of pressure, is no greater than 1/100 of the resistance before application of the pressure.

3. The circuit connecting material according to claim 2, wherein the anisotropic conductive particles comprise conductive fine particles dispersed in an organic insulating material.

4. The circuit connecting material according to claim 1 or 3, wherein the anisotropic conductive particles comprise 20-300 parts by volume of the conductive fine particles dispersed in 100 parts by volume of the organic insulating material.

5. The circuit connecting material according to any one of claims 1, 3 and 4, wherein the mean particle size of the conductive fine particles is 0.0002-0.6 times the mean particle size of the anisotropic conductive particles.

6. The circuit connecting material according to any one of claims 1 and 3-5, wherein the maximum particle size of the conductive fine particles is no greater than 0.9 times the mean particle size of the anisotropic conductive particles.

7. The circuit connecting material according to any one of claims 1 and 3-6, wherein the conductive fine particles are particles composed of a carbon material.

8. The circuit connecting material according to claim 7, wherein the carbon material is graphite.

9. The circuit connecting material according to claim 7, wherein the carbon material is carbon nanotubes.

10. The circuit connecting material according to any one of claims 1 and 3-6, wherein the conductive fine particles are particles composed of a metal material.

11. The circuit connecting material according to claim 10, wherein the metal material is silver.

12. The circuit connecting material according to claim 10, wherein the metal material is gold.

13. The circuit connecting material according to any one of claims 1, 3-7 and 10, wherein the shapes of the conductive fine particles are scaly.

14. The circuit connecting material according to any one of claims 1, 3-7 and 10, wherein the shapes of the conductive fine particles are needle-like.

15. The circuit connecting material according to any one of claims 1 and 3-14, wherein the conductive fine particles have hydrophobic-treated surfaces.

16. The circuit connecting material according to any one of claims 1 to 15, wherein the mean particle size of the anisotropic conductive particles is 0.5-30 µm.

17. The circuit connecting material according to any one of claims 1 to 16, which further comprises (1) an epoxy resin and (2) an epoxy resin curing agent.

18. The circuit connecting material according to any one of claims 1 to 16, which further comprises (3) a radical-polymerizing substance and (4) a curing agent that generates free radicals by heat or light.

19. A film-like circuit connecting material comprising the circuit connecting material according to any one of claims 1 to 18 formed into a film.

20. A structure for connecting a circuit member, comprising a first circuit member with a first connecting terminal and a second circuit member with a second connecting terminal, disposed with the first connecting terminal and second connecting terminal mutually opposing each other, wherein a circuit-connecting member comprising the cured circuit-connecting material according to any one of claims 1 to 18 is situated between the mutually opposing first connecting terminal and second connecting terminal, and the mutually opposing first connecting terminal and second connecting terminal are electrically connected.

21. The structure for connecting a circuit member according to claim 20, wherein at least one circuit member of the first circuit member and second circuit member comprises a connecting terminal having a surface composed of at least one selected from the group consisting of gold, silver, tin and platinum group metals.

22. The structure for connecting a circuit member according to claim 20 or 21, wherein at least one circuit member of the first circuit member and second circuit member comprises a connecting terminal having a surface composed of a transparent electrode made of indium-tin oxide.

23. The structure for connecting a circuit member according to any one of claims 20 to 22, wherein in at least one circuit member of the first circuit member and second circuit member, the board supporting the connecting terminal is composed of at least one material selected from the group consisting of polyester terephthalates, polyethersulfones, epoxy resins, acrylic resins, polyimide resins and glass.

24. The structure for connecting a circuit member according to any one of claims 20 to 23, wherein in at least one circuit member of the first circuit member and second circuit member, the side that contacts with the circuit-connecting member is coated with at least one type of material selected from the group consisting of silicone compounds, polyimide resins and acrylic resins.

25. The structure for connecting a circuit member according to any one of claims 20 to 23, wherein in at least one circuit member of the first circuit member and second circuit member, the side that contacts with the circuit-connecting member has at least one type of material selected from the group consisting of silicone compounds, polyimide resins and acrylic resins, attached thereto.

26. A method for connecting a circuit member, wherein a first circuit member with a first connecting terminal and a second circuit member with a second connecting terminal are disposed with the first connecting terminal and second connecting terminal mutually opposing each other, and the circuit connecting material according to any one of claims 1 to 18 is situated between the mutually opposed first connecting terminal and second connecting terminal and the stack is heated and pressed to electrically connect the mutually opposed first connecting terminal and second connecting terminal.

27. The method for connecting a circuit member according to claim 26, wherein at least one circuit member of the first circuit member and second circuit member comprises a connecting terminal having a surface composed of at least one selected from the group consisting of gold, silver, tin and platinum group metals.

28. The method for connecting a circuit member according to claim 26 or 27, wherein at least one circuit member of the first circuit member and second circuit member comprises a connecting terminal having a surface composed of a transparent electrode made of indium-tin oxide.

29. The method for connecting a circuit member according to any one of claims 26 to 28, wherein in at least one circuit member of the first circuit member and second circuit member, the board supporting the connecting terminal is composed of at least one material selected from the group consisting of polyester terephthalates, polyethersulfones, epoxy resins, acrylic resins, polyimide resins and glass.

30. The method for connecting a circuit member according to any one of claims 26 to 29, wherein in at least one circuit member of the first circuit member and second circuit member, the side that contacts with the circuit connecting material is coated with at least one type of material selected from the group consisting of silicone compounds, polyimide resins and acrylic resins.

31. The method for connecting a circuit member according to any one of claims 26 to 29, wherein in at least one circuit member of the first circuit member and second circuit member, the side that contacts with the circuit connecting material has at least one type of material selected from the group consisting of silicone compounds, polyimide resins and acrylic resins, attached thereto.
